# FASCICULE DE BREVET EUROPEEN

(11) **EP 1 774 579 B1**
(45) Date de publication et mention de la délivrance du brevet: **16.05.2012**
(21) Numéro de dépôt: 05773255.4
(22) Date de dépôt: 20.05.2005
(51) Int. Cl.: H01L 21/324, H01L 21/762, H01L 21/20

(54) **PROCÉDÉ DE RÉALISATION D'UNE STRUCTURE MULTI-COUCHES COMPORTANT, EN PROFONDEUR, UNE COUCHE DE SÉPARATION**
HERSTELLUNGSVERFAHREN FÜR EINE MEHRSCHICHTIGE STRUKTUR MIT TRENNSCHICHT
METHOD FOR PRODUCING A MULTILAYER STRUCTURE COMPRISING A SEPARATING LAYER

(30) Priorité: 01.06.2004 FR 0405883
(43) Date de publication de la demande: 18.04.2007
(73) Titulaire: Soitec, 38190 Bernin (FR)
(72) Inventeur: Bruel, Michel, 38113 Veurey Voroize (FR)
(74) Mandataire: Collin, Jérôme
(86) Numéro de dépôt international: PCT/FR2005/001262
(87) Numéro de publication internationale: WO 2006/000669

(56) Documents cités:
- WO-A2-03/046967
- US-A- 4 415 373
- US-A- 4 452 644
- US-A1- 2002 068 419
- US-A1- 2003 170 990
- US-A1- 2003 224 582
- US-B1- 6 300 208
- US-B1- 6 555 439

## Description

La présente invention se rapporte au domaine technique général du traitement de matériau, en particulier le domaine des couches minces notamment de semi-conducteurs, le domaine des plaquettes ou lames de matériau, le domaine des plaquettes ou lamelles de semi-conducteurs notamment de silicium, de semi-conducteurs de type IV, de type IV-IV, pour obtenir des composants électroniques ou opto-électroniques tels que des circuits intégrés, des éléments ou cellules photovoltaïques ou des micro-systèmes electrico-mécaniques (MEMS) ou des micro-systèmes opto-electrico-mécaniques (MOEMS) ou des dispositifs d'affichage tels que des écrans plats ou des dispositifs de prise d'images.

### Etat de la technique.

Le brevet européen EP-A-0924769 décrit un procédé dans lequel on fabrique une structure par empilement successif de plusieurs couches. Lors de sa réalisation, on empile une couche particulière située en profondeur dans la structure finale, qui présente la propriété intrinsèque, lorsqu'elle est soumise ultérieurement à un flux lumineux, d'absorber sélectivement ce flux et de conduire à un phénomène d'exfoliation permettant une division de la structure en deux plaquettes.

Selon un exemple décrit, la structure fabriquée par empilement comprend une couche en profondeur de silicium amorphe riche en hydrogène. L'application d'un flux lumineux à cette structure conduit à un dégagement rapide d'hydrogène dans cette couche, tel que la structure se divise.

### Exposé de l'invention.

L'invention a en particulier pour but de réaliser une structure multi-couches présentant, en profondeur, une couche de séparation.

L'invention a en particulier pour but de réaliser ladite couche de séparation postérieurement à la fabrication de la structure multi-couches.

L'invention a en particulier pour but de réaliser une structure multi-couches présentant, en profondeur, une couche de séparation entre une couche de surface destinée à être séparée de la structure et le reste de la structure.

L'invention a en particulier pour but de permettre un choix plus facile et varié de la structure de base sur laquelle on réalise la couche de surface destinée à être séparée

A titre d'exemple, l'invention a en particulier pour but de réaliser une couche de séparation dans une structure multi-couches dans laquelle une couche de surface destinée à être séparée est monocristalline et est obtenue par croissance sur un substrat monocristallin de même paramètre de maille, sans que la qualité de la couche de surface monocristalline et/ou du substrat monocristallin ne soit profondément affectée.

La présente invention a notamment pour objet un procédé de réalisation d'une structure multi-couches comportant, en profondeur, une couche de séparation.

Selon la présente invention, ce procédé consiste :
- à réaliser une structure initiale multi-couches comportant un substrat de base, un substrat de surface et, entre le substrat de base et le substrat de surface, une couche absorbante susceptible d'absorber un flux de puissance lumineuse sur au moins une zone et une couche intermédiaire liquéfiable comportant sur au moins une zone des impuretés présentant un coefficient de ségrégation par rapport au matériau constituant cette couche intermédiaire inférieur à l' unité;
- et à soumettre, pendant une durée déterminée et sous la forme d'au moins une impulsion, ladite structure initiale audit flux de puissance lumineuse, ce flux de puissance lumineuse étant réglé de façon à produire la liquéfaction d'au moins une partie de ladite couche intermédiaire sous l'effet de la propagation de l'énergie thermique résultant de l'absorption de puissance lumineuse dans ladite couche absorbante , de ladite couche absorbante vers ladite couche intermédiaire et/ou de l'absorption de puissance lumineuse par ladite couche intermédiaire,
   de telle sorte qu'il résulte, grâce à la présence initiale desdites impuretés, une modification d'au moins une caractéristique et/ou d'au moins une propriété de ladite couche intermédiaire à l' issue de la solidification au moins partielle de ladite couche intermédiaire, telle que cette couche intermédiaire constitue au moins partiellement une couche de séparation.

L'invention permet ainsi d'obtenir une structure finale présentant, par exemple sous une couche de surface destinée à être séparée, une couche de séparation dont les caractéristiques et/ou les propriétés sont différentes de celles du matériau initial composant la couche intermédiaire, en particulier les propriétés mécaniques et/ou les propriétés électriques et/ou optiques et/ou thermiques et/ou chimiques, de telle sorte que la séparation physique de ladite couche de surface destinée à être séparée du reste de la structure est rendue possible, par une application éventuelle si nécessaire à ladite structure finale de traitements mécaniques et/ou électriques et/ou optiques et/ou thermiques et/ou chimiques, dont les effets sur la couche de séparation sont suffisamment différenciés des effets sur le reste de la structure pour ne pas altérer ladite couche de surface et/ou ledit reste de la structure.

L'invention peut présenter de nombreuses variantes de réalisation et en particulier les suivantes.

Selon une variante préférée de l'invention, ladite modification peut avantageusement consister en une modification de la concentration et/ou de la répartition desdites impuretés dans ladite couche intermédiaire.

Selon l'invention, ladite modification peut avantageusement consister en une augmentation de la concentration et/ou de la répartition desdites impuretés dans une zone de ladite couche intermédiaire.

Selon l'invention, ladite structure initiale peut comporter un seul type de matériau.

Selon l'invention, ladite structure initiale pourrait comporter des matériaux différents.

Selon l'invention, le procédé peut avantageusement comprendre une étape préliminaire d'introduction desdites impuretés dans ladite couche intermédiaire par implantation ionique.

Selon l'invention, le matériau constituant ladite couche intermédiaire comprend de préférence du silicium et lesdites impuretés sont choisies parmi l'aluminium et/ou le bismuth et/ou le gallium et/ou l'indium et/ou l'antimoine et/ou l'étain.

Selon l'invention, le matériau constituant au moins ladite couche intermédiaire comprend de préférence du silicium-germanium.

Selon l'invention, le matériau constituant au moins ledit substrat de surface comprend de préférence du silicium ou du silicium-germanium.

Selon l'invention, le matériau constituant au moins ladite couche intermédiaire et le matériau constitutif desdites impuretés peuvent avantageusement être choisis de telle sorte que la couche de séparation comporte des inclusions.

Selon l'invention, lesdites inclusions sont de préférence constituées par des précipités et/ou des bulles et/ou des microbulles et/ou des défauts et/ou des changements de phase et/ou de composition chimique et/ou des fractures et/ou des cavités et/ou des phases hétérogénes et/ou des alliages.

Selon l'invention, le matériau constituant ladite couche intermédiaire et le matériau constitutif desdites impuretés peuvent avantageusement être choisis de telle sorte que la couche de séparation comporte des parties fragilisées.

Selon l'invention, ladite fragilisation est de préférence suffisante pour permettre la séparation physique du substrat de base et du substrat de surface, avec éventuellement l'application de forces séparatrices.

Selon l'invention, le matériau constituant ladite couche intermédiaire et le matériau constitutif desdites impuretés peuvent avantageusement être choisis de telle sorte que la couche de séparation comporte une partie de type métallique.

Selon l'invention, le matériau constituant ladite couche intermédiaire et le matériau constitutif desdites impuretés peuvent avantageusement être choisis de telle sorte que la couche de séparation comporte une partie dont la température de fusion est abaissée.

Selon l'invention, ledit abaissement de température de fusion est de préférence suffisant pour permettre, lors d'une étape ultérieure de chauffage éventuellement assortie de l'application de forces séparatrices, la séparation physique du substrat de base et du substrat de surface.

Selon une variante de l'invention, le sens du flux de puissance lumineuse peut être tel qu'il atteint ladite couche absorbante après avoir traversé ladite couche intermédiaire.

Selon une autre variante de l'invention, le sens du flux de puissance lumineuse peut être tel qu'il atteint ladite couche absorbante sans traverser ladite couche à traiter.

Selon une variante de l'invention, le procédé peut avantageusement consister à soumettre ladite structure initiale à un flux de puissance lumineuse temporellement stationnaire et balayé par rapport à cette structure.

Selon une autre variante de l'invention, le procédé peut avantageusement consister à soumettre ladite structure initiale à un flux de puissance lumineuse spatialement stationnaire et modulé sous forme d'une ou plusieurs impulsions temporelles.

Selon l'invention, ledit flux de puissance lumineuse peut avantageusement être constitué par un flux de lumière infra-rouge.

Selon l'invention, ledit flux de puissance lumineuse pourrait avantageusement être constitué par un faisceau laser.

Selon l'invention, ledit faisceau laser peut être un laser CO2

Selon l'invention, ledit faisceau laser pourrait être un laser chimique.

Selon l'invention, ledit faisceau laser peut être un laser fonctionnant à la longueur d'onde de 1,06 microns.

Selon l'invention, ladite couche d'absorption peut avantageusement comprendre au moins une zone dopée.

Selon l'invention, ladite couche d'absorption peut avantageusement comprendre au moins une zone amorphe.

Selon l'invention, ladite couche d'absorption comprend de préférence au moins une zone en silicium-germanium.

Selon l'invention, ledit substrat de surface et/ou ladite couche intermédiaire et/ou ladite couche d'absorption peuvent avantageusement être réalisés par épitaxie.

La présente invention sera mieux comprise grâce aux explications non limitatives suivantes en ce qui concerne la structure initiale et son traitement.

Le substrat de base est, dans un premier cas particulier de réalisation, un bloc de silicium monocristallin issu de la découpe longitudinale d'un lingot cylindrique. Dans un deuxième cas particulier de réalisation, le substrat de base est constitué par une plaquette de silicium de 200mm de diamètre et de 0,75 mm d'épaisseur dopée en antimoine à la concentration de 1.E19/Cm3.

La zone absorbante est une zone présentant un fort coefficient d'absorption initial pour le flux lumineux, par exemple 500 Cm-1. Il faut noter que le coefficient d'absorption dans cette zone varie en général pendant l'application de l'impulsion de flux lumineux. En effet, l'élévation de température génère elle-même en général une augmentation d'absorption générant elle-même un dépôt d'énergie plus concentré générant lui-même une élévation encore plus grande de température.

Il faut noter aussi que du fait de la diffusion thermique, il y a échauffement de proche en proche des couches et donc progression de proche en proche de l'absorption lumineuse. Tout ceci se traduit de façon générale, au cours du dépôt d'énergie, par une progression de la région de haute température et/ou de la phase liquide en direction inverse du flux de puissance lumineuse incident, avec une dynamique de progression plus rapide que celle qui correspondrait à un simple phénomène de diffusion thermique. Pour cette raison, il est judicieux en général de placer au moins une partie de la zone à traiter de telle façon que le flux de puissance incident la traverse avant d'atteindre la zone absorbante.

La zone absorbante est dans un cas particulier de réalisation tout ou partie d'une couche épitaxiale de silicium-germanium (Si0,85-Ge0,15) de 10 microns d'épaisseur, beaucoup plus absorbante à la longueur d'onde 1,06 microns que le silicium et qu'on à fait croître sur le substrat de base.

Dans un autre exemple de réalisation la zone absorbante est une zone dopée, par exemple par de l'arsenic ou de l'antimoine à la concentration de 1.E18/Cm2 à quelques 1.E19/Cm3. En effet, cette couche est absorbante pour la longueur d'onde 10,6 microns d'un laser CO2 alors que le silicium non dopé est très peu absorbant à cette longueur d'onde.

Dans un autre exemple de réalisation, la zone absorbante est réalisée par implantation à basse température d'ions silicium à l'énergie de 2 MeV et à la dose de 1.E16/Cm2 dans la couche à traiter, qui a pour effet de créer sous la surface de couche à traiter à 1,5 microns de profondeur une zone amorphisée dont le coefficient d'absorption pour la longueur d'onde 1,06 microns peut atteindre plusieurs centaines de cm-1 alors que celui du silicium cristallin se situe dans la gamme de la dizaine de cm-1.

La zone à traiter peut être, dans un cas particulier de réalisation, une couche épitaxiale de silicium dopée étain in situ pendant la croissance à la concentration de 1.E19/Cm3 qu'on a fait croître sur une couche absorbante en silicium monocristallin dopée en arsenic. Dans un autre exemple particulier de réalisation, l'étain est introduit dans ladite couche épitaxiale par l'implantation ionique d'ions étain avec la dose de 5* 10¹⁵ Cm⁻² et à l'énergie de 200 keV suivie d'un traitement thermique de diffusion de 12 heures à 1150°C.

Dans tous ces exemples dans lesquels l'on utilise la croissance épitaxiale, le procédé d'épitaxie peut-être aussi bien un procédé de type CVD, qu'un procédé de type épitaxie en phase liquide. En particulier l'épitaxie en phase liquide de silicium à partir d'un bain, par exemple d'étain ou d'aluminium ou d'indium fondu dans lequel on a dissout du silicium, peut être une des voies préférentielles pour la réalisation de cellules photovoltaïques.

La présente invention sera également mieux comprise grâce aux explications non limitatives suivantes en ce qui concerne le flux de puissance mis en oeuvre.

La durée du flux de puissance lumineux est choisie suffisamment courte et l'intensité du flux de puissance est choisie suffisamment élevée pour que le profil d'énergie thermique reste suffisamment concentré et pour que son niveau permette la liquéfaction au moins partielle de la zone à traiter.

Pour obtenir une zone de haute densité d'énergie thermique dans la zone à traiter, il est donc souhaitable :
- de choisir une longueur d'onde du faisceau lumineux telle que l'essentiel de la puissance du faisceau lumineux soit déposé dans et/ou au voisinage de la zone d'absorption ,
- de choisir une durée Δt et un flux de puissance tels que pendant l'application du flux de puissance la dynamique d'accumulation d'énergie thermique dans et au voisinage de la zone à traiter soit largement supérieure aux pertes hors de cette zone par diffusion thermique.
- et de choisir l'intensité du flux de puissance pour que, pendant la durée Δt, l'énergie apportée soit suffisante pour obtenir la liquéfaction au moins partielle de la zone à traiter

Les choix de Δt et du flux de puissance peuvent être réalisés par simulation en résolvant l'équation de la chaleur par exemple par une méthode dite des différences finies. Cette méthode et son application à l'étude de l'interaction flux lumineux avec la matière sont bien connues et sont à titre d'exemples décrits dans la référence : « Laser nitriding of metals, Peter Schaaf, Progress in Materials Science 47 (2002) 1-161 ».

Par ailleurs, avant de réaliser toute simulation, on peut connaître rapidement l'ordre de grandeur de la densité d'énergie à déposer, en utilisant la règle du pouce suivante donnée à titre d'exemple dans le cas du silicium : Il faut environ 7000J pour liquéfier un Cm3 à partir de la température ambiante. Lorsque l'on a choisi l'épaisseur que l'on souhaite liquéfier, il suffit de multiplier 7000J par l'épaisseur en question et l'on a la densité d'énergie nécessaire. Il suffit finalement de tenir compte des pertes par réflexion sur la surface pour déterminer l'ordre de grandeur de la densité d'énergie à envoyer sur la pièce

Par exemple, l'épaisseur à liquéfier peut être de 10 microns, le coefficient de réflexion peut être de 0,5 et l'ordre de grandeur de la densité d'énergie à envoyer peut être de 14J/Cm2.

La durée des impulsions laser est connue. Dans le cas d'un laser déclenché, celle-ci est, suivant le laser, de une à quelques dizaines ou centaines de nanosecondes. Cette valeur est fournie par le constructeur du laser.

De la densité d'énergie nécessaire et la durée de l'impulsion, on peut déduire le flux de puissance ; ceci donne le point de départ de la simulation. Le résultat de celle-ci permettra d'ajuster les paramètres si nécessaire.

Pour réaliser un flux de puissance sous la forme d'une impulsion, plusieurs méthodes de réalisation sont possibles :
- utilisation d'un flux de puissance stationnaire spatialement par rapport à la structure à traiter, et dont l'intensité en fonction du temps se présente sous la forme d'une ou plusieurs impulsions.
- utilisation d'un flux de puissance dont l'intensité en fonction du temps est stationnaire, mais dont la position varie par rapport au matériau de façon à ce que une région donnée du matériau ne voit le flux que pendant un ou plusieurs intervalles de temps correspondant à la durée de l'impulsion recherchée (ou des impulsions recherchées).
- ou combinaison des deux méthodes de réalisation précédentes.

Pour réaliser l'invention avec un flux de puissance lumineuse spatialement stationnaire, il est possible à titre d'exemple non limitatif d'utiliser un laser CO2 de type TEA. Cette catégorie de laser est en effet bien adaptée à la fourniture d'impulsions de forte puissance et de durée de quelques dizaines de ns à quelques centaines de nS, générant ainsi des énergies de l'ordre de quelques dizaines à quelques centaines de mJ par impulsion.

Dans un mode particulier de réalisation, on utilise un laser CO2 TEA fournissant des impulsions de 100mJ en 100nS. Le faisceau est focalisé sur une surface de 1mm², ce qui permet d'obtenir une densité de puissance de 100 MW/Cm2 et une densité d'énergie de 10J/Cm2. Afin de traiter une grande surface après chaque impulsion, on peut déplacer la pièce à traiter de façon à traiter une nouvelle partie. Ainsi, avec un laser du type précité ayant une fréquence de récurrence de 100 Hz, entre chaque impulsion on déplace la pièce à traiter d'environ 1 mm, ce qui correspond à une vitesse moyenne de 0,1 m/S et peut être réalisé par exemple en fixant la pièce à traiter sur une table motorisée.

A titre d'exemple particulier de réalisation de l'invention, pour l'obtention d'un flux de puissance lumineuse temporellement stationnaire, on peut utiliser un laser CO2 fonctionnant en mode continu et fournissant une puissance de 7kW. Le faisceau de lumière est, après sa sortie du laser, élargi par un système optique expanseur, de telle sorte que le faisceau après l'expanseur soit sensiblement parallèle et présente un diamètre d'environ 25Cm. Ce faisceau est défléchi par un miroir et se propage ensuite verticalement. Un système de focalisation se trouve ensuite sur le chemin du faisceau avec une focale de l'ordre de 1m. Le faisceau est ensuite défléchi par un miroir tournant, de telle sorte que le faisceau ainsi défléchi se propage dans un plan sensiblement horizontal. Le miroir tournant est porté par un support tournant autour d'un axe sensiblement confondu avec l'axe du système optique de focalisation. En tournant, ce miroir fait tourner l'axe du faisceau réfléchi, de telle sorte que chaque fois que le miroir fait un tour, le point de focalisation du faisceau décrit une circonférence dans un plan horizontal. La surface des pièces à traiter est placée de telle sorte qu'elle se trouve sur cette circonférence. Ainsi, à chaque rotation du miroir, les points de la surface des pièces situés sur ladite circonférence sont traités.

De façon complémentaire, pour traiter toute la surface des pièces à traiter, il est possible de fixer les structures à traiter sur un support cylindrique apte à se déplacer verticalement de telle sorte que tous les points d'une structure à traiter puissent être exposés au flux du laser.

Dans un mode particulier de réalisation, le faisceau est focalisé sur un diamètre de 80 microns, le rayon de la circonférence est de 70Cm et la vitesse de rotation du miroir est de 364 Hz, soit environ 22000 tour/minute. Dans ces conditions, chaque point est exposé à un flux de puissance de densité égale à 100MW/Cm2 de durée 100nS et de densité d'énergie égale à 14J/Cm2.

Les systèmes optiques expanseurs et de focalisation peuvent être réalisés aussi bien en optique diffractive qu'en optique réflectrice. On notera aussi qu'au lieu d'utiliser un laser fonctionnant en mode continu, il est aussi possible d'utiliser ce même type de laser fonctionnant en mode discontinu dans lequel le laser fournit une récurrence de longues impulsions (plusieurs microsecondes à plusieurs centaines de microsecondes) pendant lesquelles la puissance fournie par le laser est bien supérieure à la puissance moyenne.

Des plaquettes comportant un substrat de base en silicium dopé arsenic au niveau 1*E18/Cm³ dont la partie supérieure constitue la couche absorbante, une couche à traiter de 7 microns d'épaisseur dopée en étain à la concentration de 1*E19/Cm³, une couche épitaxiée superficielle de silicium non dopé de 20 microns d'épaisseur constituant la couche destinée à être séparée, sont fixées sur la partie périphérique intérieure de la dite surface intérieure La surface de la couche destinée à être séparée est éventuellement recouverte de couches minces par exemple des couches anti-réflectrices et/ou de couches épaisses servant par exemple de raidisseurs

L'impulsion de puissance lumineuse reçue permet de liquéfier le matériau entre environ une profondeur de 21 microns et une profondeur de 27 microns.

Ces valeurs peuvent varier sensiblement en fonction de l'évolution en fonction du temps de l'impulsion du flux de puissance et de la forme du profil d'absorption en fonction de la profondeur.

La zone liquide est ainsi limitée par une interface solide-liquide supérieure à la profondeur de 21 microns environ et une interface solide-liquide inférieure à la profondeur de 27 microns.

L'essentiel des atomes d'étain pré-existant en phase solide dans cette zone et au voisinage immédiat de celle-ci, se retrouvent dans la phase liquide. Lors de la re-solidification intervenant lors du refroidissement, les deux interfaces solide-liquide progressent chacune à leur vitesse propre l'une vers l'autre, faisant ainsi diminuer la largeur de la zone liquide.

Du fait de la faible valeur du coefficient de ségrégation (parfois appelé coefficient de distribution) de l'étain dans le silicium, c'est-à-dire du fait de la tendance des atomes d'étain à rester dans la phase liquide plutôt que de passer dans la phase solide, la progression des deux interfaces solide-liquide se traduit par un effet de poussée devant elles, dans la phase liquide, d'une grande partie des atomes d'étain, conduisant ainsi à une augmentation de plus en plus élevée de la concentration des atomes d'étain dans la phase liquide.

Corrélativement, le résultat est une tendance à appauvrir en étain de la partie re-solidifié du matériau. Globalement le résultat après la fin de la recristallisation est un profil de concentration présentant une forme de courbe en cloche très étroite dont le sommet se situe sur ou au voisinage du plan de rencontre des interfaces de solidification.

Quand la phase liquide a disparu, les atomes d'étain qui étaient présents dans la phase liquide juste avant sa disparition se retrouvent nécessairement dans le matériau à l'état solide. Ceci peut conduire localement, pour des conditions expérimentales judicieusement choisies, à une concentration très élevée d'impuretés dans une zone étroite au voisinage de la profondeur, dite profondeur de rencontre, dans laquelle les deux interfaces solide-liquide se sont rejointes et donc dans laquelle la phase liquide aura disparu totalement.

On peut éventuellement se trouver alors dans des conditions où les atomes d'étain se retrouvent à une concentration telle que ces atomes ne peuvent plus s'incorporer normalement dans la phase solide, donnant ainsi lieu à la formation d'inclusions.

Les inclusions résultantes peuvent être des agglomérats de particules, des bulles aussi bien de forme sensiblement sphérique que de forme aplatie, résultant par exemple du passage en phase gazeuse d'impuretés, des précipités d'atomes ou molécules, des précipités de défauts, des cavités, des défauts de structure, des fractures, de nouveaux composés chimiques, de nouvelles phases, des phases hétérogénes, des alliages, ou toutes combinaisons de ces éléments.

Il est ainsi possible de fragiliser le matériau au travers de ce mécanisme et de rendre possible une séparation entre la partie du matériau comprise entre la surface et la zone fragilisée et le reste du matériau.

Il est aussi possible grâce à l'invention d'obtenir, au voisinage du plan de rencontre des interfaces de solidification, la formation d'une zone dont la température de fusion est plus basse que celle du silicium. Ceci peut-être mis à profit par exemple pour séparer la partie superficielle du matériau au-dessus du plan de rencontre, du reste du matériau en chauffant l'ensemble à la température de fusion de la zone du plan de rencontre et éventuellement en exerçant des forces séparatrices.

Le phénomène de re-solidification peut-être plus complexe que celui qui est décrit précédemment. En effet, la progression des deux interfaces supérieures et inférieures peut être combinée avec une progression des interfaces latérales, et même avec la formation de zones liquides discontinues séparées par des zones re-solidifiées. Cependant, quelle que soit la complexité des mécanismes qui interviennent, cela aboutit toujours à la concentration des impuretés dans un très faible volume de matière.

Dans l'exemple précédent, on utilise l'atome d'étain. Le principe fonctionne aussi avec d'autres atomes présentant un faible coefficient de ségrégation par rapport au silicium, tels que par exemple à titre non limitatif : l'aluminium, le bismuth, le gallium, l'indium, l'étain. Cependant, si l'on utilise une longueur d'onde lumineuse dont un des mécanismes absorbants est dû aux porteurs libres, ce qui est le cas par exemple pour un laser CO2, on limitera le choix de ladite impureté à celles qui ne génèrent pas de porteurs libres de façon significative dans les conditions de l'expérience. En particulier dans le cas de l'utilisation d'un laser CO2, on n'utilisera pas les dopants tels que l'aluminium, l'indium, le gallium, le bismuth et l'antimoine ou uniquement à faible concentration.

Pour illustrer d'une manière générale et schématiquement la présente invention, en particulier les exemples et explications ci-dessus, on peut se reporter au dessin annexé sur lequel :
- la figure 1 représente une coupe d'une structure initiale selon l'invention ;
- la figure 2 représente une coupe de cette structure, en cours de traitement ;
- la figure 3 représente une coupe verticale d'un premier appareillage de traitement d'une structure initiale ;
- et la figure 4 représente une vue de dessus de l'appareillage de la figure 3.

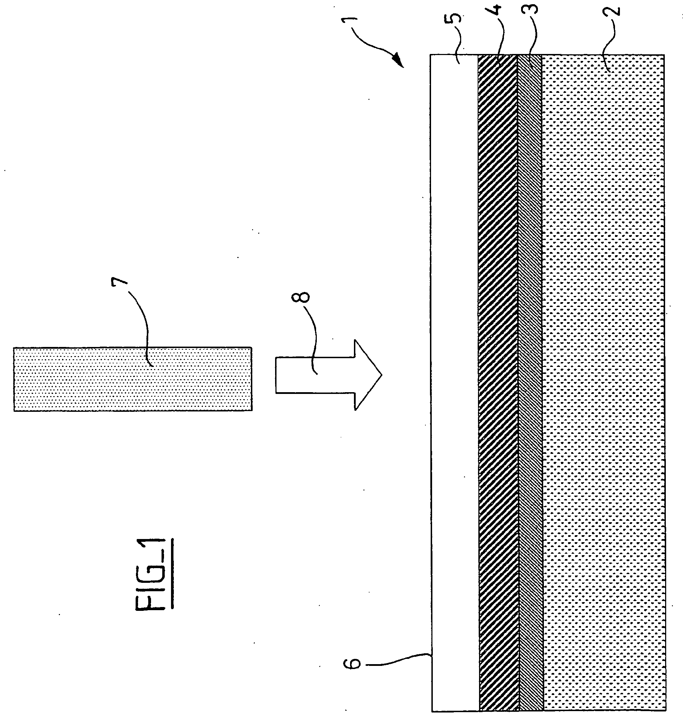

En se reportant à la figure 1, on peut voir qu'on a représenté une structure initiale multi-couches 1, à base de silicium, qui comprend un substrat de base 2 sur lequel sont formées successivement une couche absorbante 3, une couche intermédiaire 4 à traiter et un substrat de surface 5 destiné à être séparé qui présente une surface plate extérieure 6. Dans une variante, la couche absorbante 3 et la couche intermédiaire 4 pourraient être inversées.

Grâce à un appareillage 7 d'émission d'un flux impulsionnel 8 de puissance lumineuse devant et à distance de la surface plate 6, on soumet la structure initiale 1 à ce flux qui de préférence est orienté perpendiculairement à la surface 6, mais qui pourrait aussi être incliné.

Le flux de puissance lumineuse 8, introduit dans la structure 1, traverse le substrat de surface 5 et la couche intermédiaire 4, atteint la couche absorbante 3 et provoque un accroissement de la température de cette dernière et éventuellement de la liquéfaction au moins partielle du matériau la constituant.

Sous l'effet de la propagation de l'énergie thermique résultant de l'absorption du flux de puissance lumineuse 8 dans la couche absorbante 3, de cette couche absorbante 3 vers la couche intermédiaire 4, il se produit une élévation de la température et une liquéfaction du matériau d'au moins une partie de la couche intermédiaire 4, ladite élévation de température et la phase liquide 9 ainsi produite de la couche intermédiaire 4 pouvant contribuer aussi à l'absorption de la puissance lumineuse.

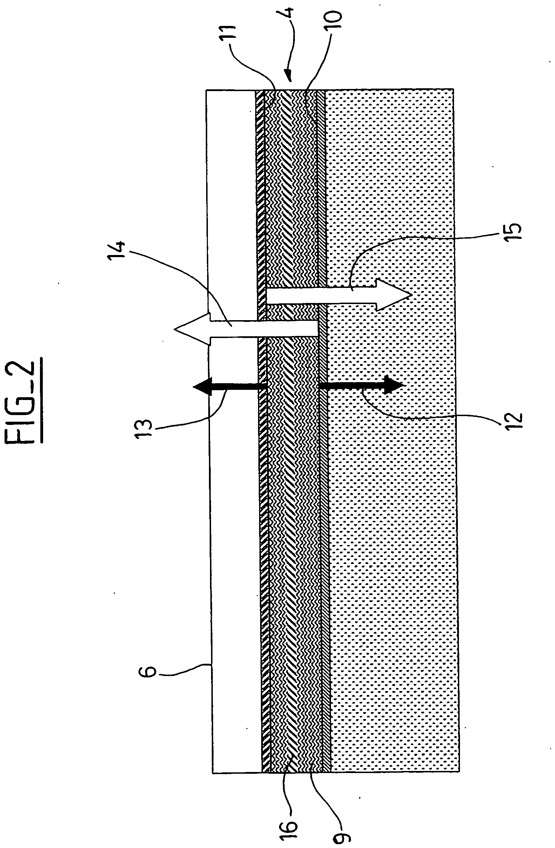

Comme le montre la figure 2, cette liquéfaction se produit de la manière suivante. La phase liquide 9, contenue approximativement entre deux interfaces solide-liquide 10 et 11 sensiblement parallèles à la surface 6, croît progressivement en épaisseur au cours de l'application du flux 4 de puissance lumineuse comme le montrent les flèches 12 et 13 attachées à ces interfaces, pour atteindre un maximum. On notera que les vitesses de progression des deux interfaces 10 et 11 peuvent être significativement différentes.

Il résulte de ce qui précède que la couche absorbante 3, qui absorbe le flux de puissance lumineuse 8 pour le transformer en énergie thermique, constitue l'élément de la structure 1 qui déclenche et qui engendre le phénomène de liquéfaction de la couche intermédiaire 4, le flux de puissance lumineuse 8 étant peu absorbé dans la région du substrat de surface 5.

La phase de liquéfaction ci-dessus est suivie d'une phase de re-solidification du matériau qui engendre une réduction progressive de l'écart entre les interfaces 10 et 11 comme le montrent les flèches 14 et 15 attachées à ces interfaces. Cette phase de re-solidification se produit en général et pour l'essentiel après l'application de l'impulsion du flux 4 de puissance lumineuse.

Lors de la phase précitée de liquéfaction du matériau, les impuretés contenues dans la couche intermédiaire 4 passent en solution dans la phase liquide 9.

Lors de la phase précitée de re-solidification du matériau, les impuretés ont tendance à rester dans la phase liquide 9 de telle sorte qu'à la fin de la phase de re-solidification du matériau, une majorité de ces impuretés se retrouvent concentrées dans une partie ou couche 16 de la couche intermédiaire initiale 4 se re-solidifiant en dernier, c'est-à-dire dans un volume de silicium dont l'épaisseur est beaucoup plus faible, par exemple de l'ordre de quelques dizaines de nanomètres, que l'épaisseur maximum précitée de la phase liquide 9.

Ces impuretés peuvent alors se retrouver dans la partie 16 éventuellement à des niveaux de concentration bien supérieurs à celui de la solubilité limite en phase solide, générant ainsi la formation de précipités et/ou de défauts cristallins fragilisant le matériau dans la zone de concentration 16.

De façon générale, la forte concentration d'impuretés dans la partie 16 modifie de façon significative les propriétés ou les caractéristiques du matériau pour qu'il soit possible d'appliquer un traitement ultérieur à la structure 1 altérant la partie 16 et n'altérant pas le reste de cette structure.

Ce traitement ultérieur de la structure 1 peut avantageusement permettre de diviser en deux plaquettes la structure 1, dont l'une comprend le substrat de base 2 et l'autre le substrat de surface 5, en produisant cette séparation au niveau de la partie ou couche fragilisée 16 à concentration accrue d'impuretés. Par exemple, l'exercice de forces associées ou non à un traitement thermique, ou inversement, peut être utilisé pour réaliser cette séparation.

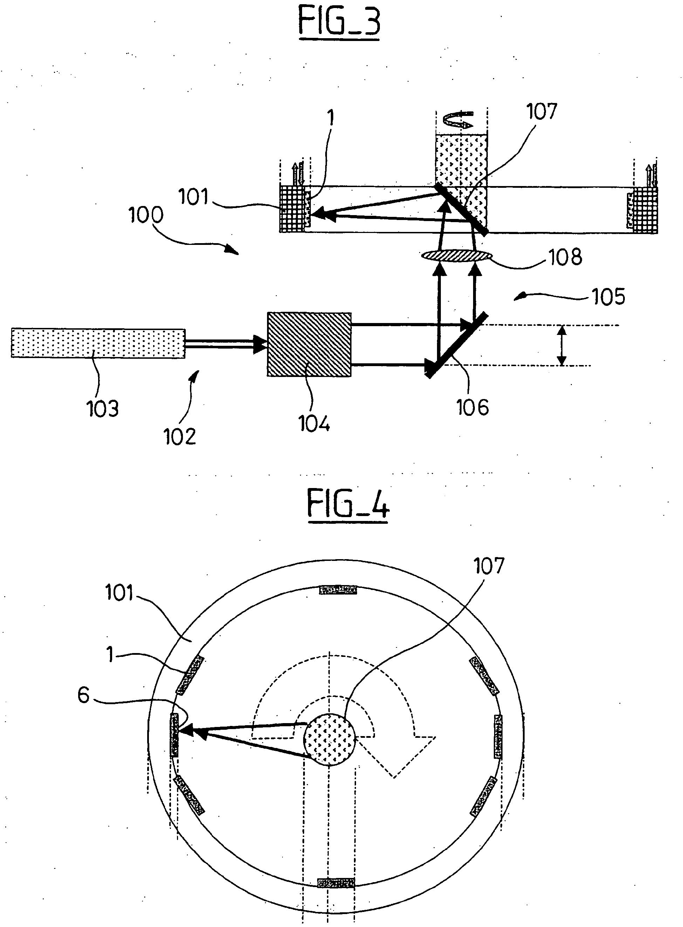

En se reportant aux figures 3 et 4, on peut voir qu'on a représenté un appareillage 100 de traitement de structures initiales 1.

Cet appareillage comprend un support cylindrique 101 à axe vertical, sur une face intérieure duquel sont fixées, réparties sur une circonférence, des structures initiales 1 à traiter dont les faces 6 sont placées verticalement sont tournées vers l'axe du support 101.

L'appareillage 100 comprend un générateur 102 de flux de puissance lumineuse temporellement stationnaire, placé en dessous du support 101 et comprenant un émetteur laser 103 qui émet vers un expanseur optique 104 de telle sorte que le flux sortant de cet expanseur 104 est horizontal et dont l'axe coupe l'axe du support 101.

L'appareillage 100 comprend un système optique 105 qui comprend un miroir fixe 106 incliné à 45° qui dévie vers le haut, verticalement, le flux sortant de l'expanseur 104 en direction d'un miroir tournant 107, via une lentille de focalisation 108, ce miroir tournant 107 étant placé au centre du support 101, à 45°, et son axe de rotation étant disposé selon l'axe du support 101, de telle sorte que le flux de puissance lumineuse réfléchi par le miroir tournant 105 est orienté vers la face intérieure du support 101.

Ainsi, lorsque le miroir tournant 107 est entraîné en rotation, le flux de puissance lumineuse balaye horizontalement, successivement, les structures à traiter 1. en actionnant des moyens de déplacement vertical, non représenté, du support 101, on peut alors provoquer un balayage total de la surface 6 des structures à traiter 1 sous forme d'impulsions.

La présente invention ne se limite pas aux exemples ci-dessus décrits. Bien de variantes sont possibles sans sortir du cadre des revendications annexées.

## Revendications

1. Procédé de réalisation d'une structure multi-couches comportant, en profondeur, une couche de séparation, **caractérisé en ce qu'** il consiste :
- à réaliser une structure initiale multi-couches (1) comportant un substrat de base (2), un substrat de surface (5) et, entre le substrat de base et le substrat de surface, une couche absorbante (3) susceptible d'absorber un flux de puissance lumineuse sur au moins une zone et une couche intermédiaire liquéfiable (4) comportant sur au moins une zone des impuretés présentant un coefficient de ségrégation par rapport au matériau constituant cette couche intermédiaire inférieur à un ;
- et à soumettre, pendant une durée déterminée et sous la forme d'au moins une impulsion, ladite structure initiale (1) audit flux de puissance lumineuse, ce flux de puissance lumineuse étant réglé de façon à produire la liquéfaction d'au moins une partie de ladite couche intermédiaire (4) sous l'effet de la propagation de l'énergie thermique résultant de l'absorption de puissance lumineuse dans ladite couche absorbante (3), de ladite couche absorbante (3) vers ladite couche intermédiaire (4) et/ou de l'absorption de puissance lumineuse par ladite couche intermédiaire (4),
de telle sorte qu'il résulte, grâce à la présence initiale desdites impuretés, une modification d'au moins une caractéristique et/ou d'au moins une propriété de ladite couche intermédiaire (4) à l'issue de la solidification au moins partielle de ladite couche intermédiaire, telle que cette couche intermédiaire constitue au moins partiellement une couche de séparation (16).

2. Procédé selon la revendication 1, **caractérisé par le fait que** ladite modification consiste en une modification de la concentration et/ou de la répartition desdites impuretés dans ladite couche intermédiaire.

3. Procédé selon l'une des revendications précédentes, **caractérisé par le fait que** ladite modification consiste en une augmentation de la concentration et/ou de la répartition desdites impuretés dans une zone de ladite couche intermédiaire.

4. Procédé selon la revendication 1, **caractérisé par le fait que** ladite structure initiale comporte un seul type de matériau.

5. Procédé selon la revendication 1, **caractérisé par le fait que** ladite structure initiale comporte des matériaux différents.

6. Procédé selon la revendication 1, **caractérisé par le fait qu'**il comprend une étape préliminaire d'introduction desdites impuretés dans ladite couche intermédiaire par implantation ionique.

7. Procédé selon la revendication 1, **caractérisé par le fait que** le matériau constituant ladite couche intermédiaire comprend du silicium et lesdites impuretés sont choisies parmi l'aluminium et/ou le bismuth et/ou le gallium et/ou l'indium et/ou l'antimoine et/ou l'étain.

8. Procédé selon la revendication 1, **caractérisé par le fait que** le matériau constituant au moins ladite couche intermédiaire comprend du silicium-germanium.

9. Procédé selon la revendication 1, **caractérisé par le fait que** le matériau constituant au moins ledit substrat de surface comprend du silicium ou du silicium-germanium.

10. Procédé selon la revendication 1, **caractérisé par le fait que** le matériau constituant au moins ladite couche intermédiaire et le matériau constitutif desdites impuretés sont choisis de telle sorte que la couche de séparation comporte des inclusions.

11. Procédé selon la revendication 10, **caractérisé par le fait que** lesdites inclusions sont constituées par des précipités et/ou des bulles et/ou des microbulles et/ou des défauts et/ou des changements de phase et/ou de composition chimique et/ou des fractures et/ou des cavités et/ou des phases hétérogènes et/ou des alliages.

12. Procédé selon la revendication 1, **caractérisé par le fait que** le matériau constituant ladite couche intermédiaire et le matériau constitutif desdites impuretés sont choisis de telle sorte que la couche de séparation comporte des parties fragilisées.

13. Procédé selon la revendication 12, **caractérisé en ce que** ladite fragilisation est suffisante pour permettre la séparation physique du substrat de base et du substrat de surface, avec éventuellement l'application de forces séparatrices.

14. Procédé selon la revendication 1, **caractérisé par le fait que** le matériau constituant ladite couche intermédiaire et le matériau constitutif desdites impuretés sont choisis de telle sorte que la couche de séparation comporte une partie de type métallique.

15. Procédé selon la revendication 1, **caractérisé par le fait que** le matériau constituant ladite couche intermédiaire et le matériau constitutif desdites impuretés sont choisis de telle sorte que la couche de séparation comporte une partie dont la température de fusion est abaissée.

16. Procédé selon la revendication 15, **caractérisé par le fait que** ledit abaissement de température de fusion est suffisant pour permettre, lors d'une étape ultérieure de chauffage éventuellement assorti de l'application de forces séparatrices, la séparation physique du substrat de base et du substrat de surface.

17. Procédé selon la revendication 1, **caractérisé par le fait que** le sens du flux de puissance lumineuse est telle qu'il atteint ladite couche absorbante après avoir traversé ladite couche intermédiaire.

18. Procédé selon la revendication 1, **caractérisé par le fait que** le sens du flux de puissance lumineuse est telle qu'il atteint ladite couche absorbante sans traverser ladite couche à traiter.

19. Procédé selon la revendication 1, **caractérisé par le fait qu'**'il consiste à soumettre ladite structure initiale à un flux de puissance lumineuse temporellement stationnaire et balayé par rapport à cette structure.

20. Procédé selon la revendication 1, **caractérisé par le fait qu'**il consiste à soumettre ladite structure initiale à un flux de puissance lumineuse spatialement stationnaire et modulé sous forme d'une ou plusieurs impulsions temporelles.

21. Procédé selon la revendication 1, **caractérisé par le fait que** ledit flux de puissance lumineuse est constitué par un flux de lumière infra-rouge.

22. Procédé selon la revendication 1, **caractérisé par le fait que** ledit flux de puissance lumineuse est un faisceau laser.

23. Procédé selon la revendication 22, **caractérisé par le fait que** ledit faisceau laser est un laser CO2.

24. Procédé selon la revendication 22, **caractérisé par le fait que** ledit faisceau laser est un laser chimique.

25. Procédé selon la revendication 22, **caractérisé par le fait que** ledit faisceau laser est un laser fonctionnant à la longueur d'onde de 1,06 microns.

26. Procédé selon la revendication 1, **caractérisé par le fait que** ladite couche d'absorption comprend au moins une zone dopée.

27. Procédé selon la revendication 1, **caractérisé par le fait que** ladite couche d'absorption comprend au moins une zone amorphe.

28. Procédé selon la revendication 1, **caractérisé par le fait que** ladite couche d'absorption comprend au moins une zone en silicium-germanium.

29. Procédé selon la revendication 1, **caractérisé par le fait que** ledit substrat de surface et/ou ladite couche intermédiaire et/ou ladite couche d'absorption sont réalisées par épitaxie.

## Claims

1. Method for producing a multilayer structure comprising a separating layer in the depth thereof, **characterised in that** it consists:
- in producing an initial multi-layer structure (1) comprising a base substrate (2), a surface substrate (5) and, between the base substrate and the surface substrate, an absorbent layer (3) that can absorb a light power flux in at least one region and a liquefiable intermediate layer (4) comprising in at least one region impurities having a segregation coefficient less than one in relation to the material forming this intermediate layer;
- and in subjecting, over a determined duration and in the form of at least one pulse, said initial structure (1) to said light power flux, this light power flux being regulated in such a way as to produce the liquefaction of at least one part of said intermediate layer (4) under the effect of the propagation of the thermal energy resulting from the absorption of light power in said absorbent layer (3), from said absorbent layer (3) towards said intermediate layer (4) and/or of the absorption of light power by said intermediate layer (4),
in such a way that that this results, thanks to the initial presence of said impurities, in a modification of at least one characteristic and/or of at least one property of said intermediate layer (4) after the at least partial solidification of said intermediate layer, such that this intermediate layer constitutes at least partially a separating layer (16).

2. Method according to claim 1, **characterised by** the fact that said modification consists in a modification of the concentration and/or of the distribution of said impurities in said intermediate layer.

3. Method according to one of the preceding claims, **characterised by** the fact that said modification consists in an increase in the concentration and/or of the distribution of said impurities in a region of said intermediate layer.

4. Method according to claim 1, **characterised by** the fact that said initial structure comprises a single type of material.

5. Method according to claim 1, **characterised by** the fact that said initial structure comprises different materials.

6. Method according to claim 1, **characterised by** the fact that it includes a preliminary step of introducing said impurities in said intermediate layer via ion implantation.

7. Method according to claim 1, **characterised by** the fact that the material comprising said intermediate layer includes silicon and said impurities are chosen from among aluminum and/or bismuth and/or gallium and/or indium and/or antimony and/or tin.

8. Method according to claim 1, **characterised by** the fact that the material comprising at least said intermediate layer includes silicon-germanium.

9. Method according to claim 1, **characterised by** the fact that the material comprising at least said surface substrate includes silicon or silicon-germanium.

10. Method according to claim 1, **characterised by** the fact that the material comprising at least said intermediate layer and the material comprising said impurities are chosen in such a way that the separating layer comprises inclusions.

11. Method according to claim 10, **characterised by** the fact that said inclusions are comprised of precipitates and/or bubbles and/or microbubbles and/or defects and/or changes in phase and/or in chemical composition and/or fractures and/or cavities and/or heterogeneous and/or alloys.

12. Method according to claim 1, **characterised by** the fact that the material comprising said intermediate layer and the material comprising said impurities are chosen in such a way that the separating layer comprises weakened parts.

13. Method according to claim 12, **characterised in that** said weakening is sufficient to allow for the physical separation of the base substrate and of the surface substrate, with possibly the application of separating forces.

14. Method according to claim 1, **characterised by** the fact that the material comprising said intermediate layer and the material comprising said impurities are chosen in such a way that the separating layer comprises a portion of the metal type.

15. Method according to claim 1, **characterised by** the fact that the material comprising said intermediate layer and the material comprising said impurities are chosen in such a way that the separating layer comprises a portion of which the melting temperature is lowered.

16. Method according to claim 15, **characterised by** the fact that said lowering of the melting temperature is sufficient to allow for, during a later step of heating possibly along with the application of separating forces, the physical separation of the base substrate and of the surface substrate.

17. Method according to claim 1, **characterised by** the fact that the direction of the light power flux is such that it reaches said absorbent layer after having passed through said intermediate layer.

18. Method according to claim 1, **characterised by** the fact that the direction of the light power flux is such that it reaches said absorbent layer without passing through said layer to be treated.

19. Method according to claim 1, **characterised by** the fact that it consists in subjecting said initial structure to a light power flux that is stationary in terms of time and swept in relation to this structure.

20. Method according to claim 1, **characterised by** the fact that it consists in subjecting said initial structure to a light power flux that is temporally stationary and modulated in the form of one or several temporal pulses.

21. Method according to claim 1, **characterised by** the fact that said light power flux is comprised of a flux of infrared light.

22. Method according to claim 1, **characterised by** the fact that said light power flux is a laser beam.

23. Method according to claim 22, **characterised by** the fact that said laser beam is a CO2 laser.

24. Method according to claim 22, **characterised by** the fact that said laser beam is a chemical laser.

25. Method according to claim 22, **characterised by** the fact that said laser beam is a laser operating on a wavelength of 1.06 microns.

26. Method according to claim 1, **characterised by** the fact that said absorption layer includes at least one doped region.

27. Method according to claim 1, **characterised by** the fact that said absorption layer includes at least one amorphous region.

28. Method according to claim 1, **characterised by** the fact that said absorption layer includes at least one region made of silicon-germanium.

29. Method according to claim 1, **characterised by** the fact that said surface substrate and/or said intermediate layer and/or said absorption layer are produced via epitaxy.

## Patentansprüche

1. Verfahren zur Herstellung einer Mehrschichtstruktur, die in der Tiefe eine Trennschicht umfasst, **dadurch gekennzeichnet, dass** es aus dem Folgenden besteht:
- eine anfängliche Mehrlagenschicht (1) herzustellen, die ein Basissubstrat (2), ein Oberflächensubstrat (5) und zwischen dem Basissubstrat und dem Oberflächensubstrat eine absorbierende Schicht (3), die einen Leuchtkraftfluss auf mindestens einer Zone absorbieren kann, und eine verflüssigbare Zwischenschicht (4) umfasst, die auf mindestens einer Zone Verunreinigungen umfasst, welche bezüglich des Materials, das diese Zwischenschicht aufbaut, einen Entmischungskoeffizienten unterhalb von 1 aufweisen;
- und während einer festgelegten Dauer und in Form mindestens eines Impulses die anfängliche Struktur (1) dem Leuchtkraftfluss auszusetzen, wobei der Leuchtkraftfluss so geregelt ist, dass er unter dem Einfluss der Weiterleitung der aus der Leuchtkraftabsorption in der absorbierenden Schicht (3) resultierenden thermischen Energie von der absorbierenden Schicht (3) zur Zwischenschicht (4) und/oder der Leuchtkraftabsorption durch die Zwischenschicht (4) die Verflüssigung mindestens eines Teils der Zwischenschicht (4) erzeugt,
derart, dass aufgrund der anfänglichen Anwesenheit der Verunreinigungen eine Modifikation mindestens eines Merkmals und/oder mindestens einer Eigenschaft der Zwischenschicht (4) am Ende der mindestens teilweisen Verfestigung der Zwischenschicht resultiert, so dass die Zwischenschicht zumindest teilweise eine Trennschicht (16) darstellt.

2. Verfahren nach Anspruch 1, **dadurch gekennzeichnet, dass** die Modifikation aus einer Modifikation der Konzentration und/oder der Verteilung der Verunreinigungen in der Zwischenschicht besteht.

3. Verfahren nach einem der vorangehenden Ansprüche, **dadurch gekennzeichnet, dass** die Modifikation in einer Erhöhung der Konzentration und/oder der Verteilung der Verunreinigungen in einer Zone der Zwischenschicht besteht.

4. Verfahren nach Anspruch 1, **dadurch gekennzeichnet, dass** die anfängliche Struktur eine einzige Materialart umfasst.

5. Verfahren nach Anspruch 1, **dadurch gekennzeichnet, dass** die anfängliche Struktur verschiedene Materialien umfasst.

6. Verfahren nach Anspruch 1, **dadurch gekennzeichnet, dass** es einen vorangehenden Schritt der Einführung der Verunreinigungen in die Zwischenschicht durch Ionenimplantation umfasst.

7. Verfahren nach Anspruch 1, **dadurch gekennzeichnet, dass** das Material, aus dem die Zwischenschicht aufgebaut ist, Silicium umfasst und die Verunreinigungen aus Aluminium und/oder Bismut und/oder Gallium und/oder Indium und/oder Antimon und/oder Zinn ausgewählt sind.

8. Verfahren nach Anspruch 1, **dadurch gekennzeichnet, dass** das Material, aus dem zumindest die Zwischenschicht aufgebaut ist, Silicium-Germanium umfasst.

9. Verfahren nach Anspruch 1, **dadurch gekennzeichnet, dass** das Material, aus dem zumindest das Oberflächensubstrat aufgebaut ist, Silicium und/oder Silicium-Germanium umfasst.

10. Verfahren nach Anspruch 1, **dadurch gekennzeichnet, dass** das Material, aus dem zumindest die Zwischenschicht aufgebaut ist, und das Material, aus dem die Verunreinigungen bestehen, derart gewählt werden, dass die Trennschicht Einschlüsse umfasst.

11. Verfahren nach Anspruch 10, **dadurch gekennzeichnet, dass** die Einschlüsse aus Ausfällungen und/oder aus Blasen und/oder aus Mikroblasen und/oder aus Defekten und/oder aus Phasenänderungen und/oder aus chemischer Zusammensetzung und/oder aus Frakturen und/oder aus Hohlräumen und/oder aus heterogenen Phasen und/oder aus Legierungen bestehen.

12. Verfahren nach Anspruch 1, **dadurch gekennzeichnet, dass** das Material, aus dem die Zwischenschicht aufgebaut ist, und das Material, aus dem die Verunreinigungen bestehen, derart gewählt sind, dass die Trennschicht brüchige Teile umfasst.

13. Verfahren nach Anspruch 12, **dadurch gekennzeichnet, dass** das Brüchigkeit ausreichend ist, um die physikalische Abtrennung des Basissubstrats und des Oberflächensubstrats gegebenenfalls unter Anwendung von Trennungskräften zu ermöglichen.

14. Verfahren nach Anspruch 1, **dadurch gekennzeichnet, dass** das Material, aus dem die Zwischenschicht aufgebaut ist, und das Material, aus dem die Verunreinigungen bestehen, derart gewählt sind, dass die Trennschicht einen Teil vom metallischen Typ umfasst.

15. Verfahren nach Anspruch 1, **dadurch gekennzeichnet, dass** das Material, aus dem die Zwischenschicht aufgebaut ist, und das Material, aus dem die Verunreinigungen bestehen, derart gewählt sind, dass die Trennschicht einen Teil umfasst, dessen Schmelztemperatur herabgesetzt ist.

16. Verfahren nach Anspruch 15, **dadurch gekennzeichnet, dass** die Herabsetzung der Schmelztemperatur ausreichend ist, um bei einem späteren Erwärmungsschritt gegebenenfalls zusammen mit der Anwendung von Trennungskräften die physikalische Trennung des Basissubstrats und des Oberflächensubstrats zu ermöglichen.

17. Verfahren nach Anspruch 1, **dadurch gekennzeichnet, dass** die Richtung des Leuchtkraftflusses derart ist, dass er die absorbierende Schicht erreicht, nachdem er durch die Zwischenschicht getreten ist.

18. Verfahren nach Anspruch 1, **dadurch gekennzeichnet, dass** die Richtung des Leuchtkraftflusses derart ist, dass er die absorbierende Schicht erreicht, ohne die zu behandelnde Schicht zu durchqueren.

19. Verfahren nach Anspruch 1, **dadurch gekennzeichnet, dass** es darin besteht, die anfängliche Struktur einem zeitweise stationären und bezüglich dieser Struktur überfluteten Leuchtkraftfluss auszusetzen.

20. Verfahren nach Anspruch 1, **dadurch gekennzeichnet, dass** es darin besteht, die anfängliche Struktur einem Leuchtkraftfluss auszusetzen, der räumlich stationär und in Form eines oder mehrerer temporärer Impulse moduliert ist.

21. Verfahren nach Anspruch 1, **dadurch gekennzeichnet, dass** der Leuchtkraftfluss aus einem Infrarot-Lichtfluss besteht.

22. Verfahren nach Anspruch 1, **dadurch gekennzeichnet, dass** der Leuchtkraftfluss ein Laserstrahl ist.

23. Verfahren nach Anspruch 22, **dadurch gekennzeichnet, dass** der Laserstrahl ein CO2-Laser ist.

24. Verfahren nach Anspruch 22, **dadurch gekennzeichnet, dass** der Laserstrahl ein chemischer Laser ist.

25. Verfahren nach Anspruch 22, **dadurch gekennzeichnet, dass** der Laserstrahl ein Laser ist, der bei einer Wellenlänge von 1,06 Mikrometer arbeitet.

26. Verfahren nach Anspruch 1, **dadurch gekennzeichnet, dass** die Absorptionsschicht mindestens eine dotierte Zone umfasst.

27. Verfahren nach Anspruch 1, **dadurch gekennzeichnet, dass** die Absorptionsschicht mindestens eine amorphe Zone umfasst.

28. Verfahren nach Anspruch 1, **dadurch gekennzeichnet, dass** die Absorptionsschicht mindestens eine Zone aus Silicium-Germanium umfasst.

29. Verfahren nach Anspruch 1, **dadurch gekennzeichnet, dass** das Oberflächensubstrat und/oder die Zwischenschicht und/oder die Absorptionsschicht durch Epitaxie hergestellt werden.
